# EUROPÄISCHE PATENTSCHRIFT

(11) **EP 1 580 446 B1**
(45) Veröffentlichungstag und Bekanntmachung des Hinweises auf die Patenterteilung: **05.10.2005**
(21) Anmeldenummer: 04007325.6
(22) Anmeldetag: 26.03.2004
(51) Int. Cl.: F16C 13/00, C23C 14/56

(54) **Verfahren zum Betrieb von Vakuumanlagen mit Drückänderungen**
Method of operating a vacuum system with varying pressure
Procédé d'opération d'un appareil à vide avec variation de pression

(43) Veröffentlichungstag der Anmeldung: 28.09.2005
(73) Patentinhaber: Applied Films GmbH & Co. KG, 63755 Alzenau (DE)
(72) Erfinder: Hein, Stefan, 63825 Blankenbach (DE); Klemm, Günter, 63667 Nidda (DE)
(74) Vertreter: Zapfe, Hans

(56) Entgegenhaltungen:
- EP-A- 0 470 332
- DE-A- 3 733 448
- DE-A- 3 919 425
- DE-U- 8 813 091
- US-A1- 2003 046 968

## Beschreibung

Die Erfindung betrifft ein Verfahren zum Betrieb von Vakuumanlagen mit Druckänderungen zwischen dem Betriebsdruck und dem Umgebungsdruck, die in einer Vakuumkammer Einbauteile aus der Gruppe Elektronikbauteile, Transformatoren, Motoren, Wälzlager und Führungswalzen besitzen, die mit belüftbaren Umhüllungen versehen sind, wobei die Führungswalzen mit Wälzlagern versehen sind, die innerhalb der Umhüllungen auf Stützkörpern gehalten sind.

Die Änderung zwischen dem Betriebsdruck, der meist im Bereich des Hochvakuums liegt und durch Verfahrenbedingungen vorgegeben ist, und dem Umgebungsdruck bzw. Atmosphärendruck erfolgt insbesondere dann, wenn ein Substratwechsel, ein Nachschub an Beschichtungsmaterial, eine Wartung, Reparatur oder Umrüstung erforderlich ist. Der Druckanstieg erfolgt durch einen Vorgang, der auch als "Fluten" bezeichnet wird, bevor eine Verschlussvorrichtung der Vakuumkammer geöffnet werden kann. Dieses Fluten durch ein entsprechend dimensioniertes Flutventil führt jedoch dazu, dass in der Vakuumkammer abgelagerter Staub oder andere Partikel aufgewirbelt und in den Schwebezustand gebracht werden.

Nun befinden sich in der Regel in der Vakuumkammer zahlreiche Einbauteile aus der Gruppe Elektronikbauteile, Transformatoren, Motoren, Wälzlager und Führungswalzen, die mit belüftbaren Umhüllungen versehen sind, beispielsweise mit Gehäusen, Kapseln oder dergleichen. Die Führungswalzen oder deren Abschnitte bilden sogar selbst Umhüllungen für die in ihnen untergebrachten Wälzlager. Von den Führungswalzen geführte Bänder wie Papier, Metall- und Kunststoff-Folien bilden gleichfalls eine Art "Umhüllung", die den Gasaustausch behindert und verzögert.

Der Druckanstieg in den besagten Umhüllungen erfolgt daher in der Regel langsamer als in der verhältnismässig rasch gefluteten Vakuumkammer, so dass die besagten Schwebstoffe die Tendenz haben, durch öffnungen, Spalte, ja sogar durch unvollkommene Dichtungen, in die Umhüllungen einzudringen und dort Schäden zu verursachen.

Durch die DE 27 25 331 C2 ist es bekannt, die Wälzlager von sog. Breitstreckwalzen für einen Bandtransport innerhalb von Kammern durch eine Ölnebel-Druckschmieranlage zu schmieren, wobei innerhalb der bogenförmig gekrümmten Walze zwei Kanäle für die Hin- und Rückleitung des Ölnebels, bzw. der restlichen Luft angeordnet sind. Das beschriebene Verfahren funktioniert jedoch nur dann, wenn die Breitstreckwalze zur Kammer hin abgedichtet ist, was entweder durch einen elastomeren überzug der Walze oder durch elastomere Verbindungsstücke von starren zylindrischen Walzenabschnitten erreicht wird. Ein Spülen der Umgebung der Walze und die Beseitigung von Staub und anderen Partikeln aus dem Behandlungsverfahren des Bandes ist dadurch nicht möglich, insbesondere dann nicht, wenn beim Fluten oder während der Flutens der Anlage durch ein Flutventil Staub und andere Partikel aufgewirbelt werden, die im Schwebezustand die Tendenz haben, bei der durch das Fluten bedingten Drucksteigerung in alle nicht abgedichteten Hohlräume einzudringen.

Durch die DE 37 33 448 A1 ist es bekannt, beidseitig abgedichtete Wälzlager von sog. Breitstreckwalzen für einen Bandtransport durch eine Druckschmierung einzeln mit Fetten oder ölen zu schmieren, wobei innerhalb der bogenförmig gekrümmten Walze zwei Kanäle für die Hin- und Rückleitung der Schmiermittel angeordnet sind. Eine Beimischung von Luft oder einem anderen Gas ist jedoch nicht angesprochen, so dass eine Spülung der Umgebung durch Gase ebenso wenig möglich ist, wie eine Gasspülung des Innenraums der Walze oder anderer Komponenten.

Durch die DE 39 19 425 C2 ist es bekannt, die Fettfüllung der einzelnen Wälzlager von gekrümmten, auf dem Umfang geschlossenen Breitstreckwalzen periodisch gesteuert mit Grundöl nachzufetten. Eine Beimischung von Luft oder einem anderen Gas ist jedoch nicht angesprochen, so dass eine Spülung der Umgebung durch Gase ebenso wenig möglich ist, wie eine Gasspülung des Innenraums der Walze oder anderer Komponenten.

Aus dem Dokument EP-A-0 470 332 ist ein Verfahren nach dem Oberbegriff des Anspruchs 1 bekannt.

Bei dem gesamten Stand der Technik wird nicht berücksichtigt, dass in einer Vakuumkammer beim Fluten mit Umgebungsluft zum Zwecke eines Bandwechsels unter Atmosphärendruck Staub und andere Partikel aufgewirbelt werden, die beispielsweise auch aus einem vorausgegangenen Beschichtungsprozess stammen können und die durch die Drucksteigerung in alle Umhüllungen, Gehäuse oder dgl. von Einbauteilen eindringen und deren Funktion erheblich stören können. Das gilt für die Innenräume von Breitstreckwalzen mit Wälzlagern ebenso wie für die Innenräume von elektrischen oder elektronischen Bauelementen. Besonders gefährlich ist hierbei Zinkstaub, der beim Beschichten von Folien durch Verdampfen von Zink im Vakuum entsteht. Zink kondensiert im Innern der Vakuumkammer auf beliebigen Flächen und bildet zusammen mit Luftsauerstoff Zinkoxid, dessen Ansammlung in Wälzlagern bis zu deren Stillstand führen kann.

Hierbei ist besonders zu berücksichtigen, dass Breitstreckwalzen in der Regel keinen eigenen Antrieb besitzen, sondern von der zu streckenden Folie "geschleppt" werden müssen, was sich bei empfindlichen Kunststoff-Folien im Dickenbereich um die 0,002 mm besonders negativ auswirkt.

Der Erfindung liegt daher die Aufgabe zugrunde, ein Verfahren der eingangs beschriebenen Gattung dahingehend weiter zu entwickeln, dass alle in der Vakummkammer bzw. -anlage eingeschlossenen und von einer luftdurchlässigen Umhüllung bzw. einem Gehäuse umgebenen Einbauteile aus der Gruppe Elektronikbauteile, Transformatoren, Motoren, Lager und Führungswalzen gegen das Eindringen von aufgewirbeltem und schwebendem Staub und anderen Partikeln beim Fluten vom Betriebsdruck (Vakuum) auf Umgebungsdruck geschützt werden.

Die Lösung der gestellten Aufgabe erfolgt bei dem eingangs angegeben Verfahren erfindungsgemäss dadurch, dass vor dem Fluten der Vakuumkammer in die Umhüllungen ein Gas eingeleitet wird, durch das Festkörper aus der Gruppe Staub und Partikel aus der Umhüllung herausgeblasen werden und das Eindringen von Festkörpern in die Umhüllung verhindert wird.

Durch diese Massnahme wird die gestellte Aufgabe in vollem Umfange gelöst, d.h. es werden alle in der Vakuumkammer bzw. -anlage eingeschlossenen und von einer luftdurchlässigen Umhüllung bzw. einem Gehäuse umgebenen Einbauteile aus der Gruppe Elektronikbauteile, Transformatoren, Motoren, Lager und Führungswalzen gegen das Eindringen von aufgewirbeltem und schwebendem Staub und anderen Partikeln beim Fluten vom Betriebsdruck (Vakuum) auf Umgebungsdruck geschützt. Das durch den Gasdurchfluss langsamer abnehmende Vakuum in den Einbauteilen ist gewissermassen ein Zeit lang ein Reinigungsmittel und ein Puffer gegen das Eindringen von Fremdstoffen.

Es ist im Zuge weiterer Ausgestaltungen der Erfindung besonders vorteilhaft, wenn - entweder einzeln, oder in Kombination - :
* die Umhüllungen aus hohlen Walzen bzw. Walzenabschnitten bestehen, in denen sich Wälzlager mit Innenringen und Aussenringen befinden und wenn das Gas durch die Ringspalte zwischen den Innenringen und den Aussenringen hindurch geblasen wird, und/oder, wenn
* das Gas während des gesamten Flutvorganges der Vakuumkammer durch die besagten Umhüllungen hindurch geführt wird.

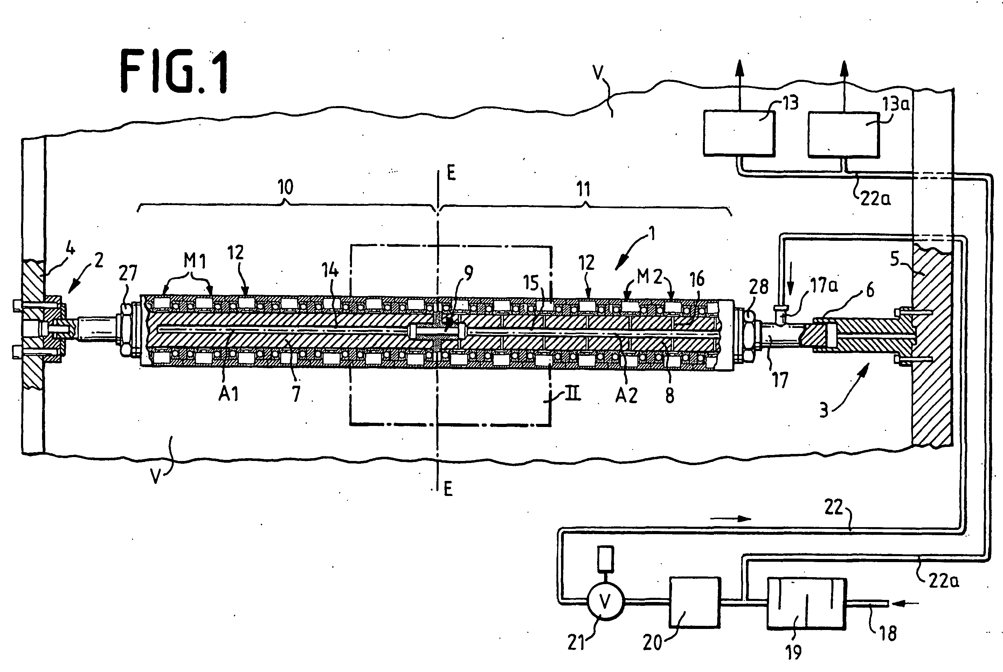

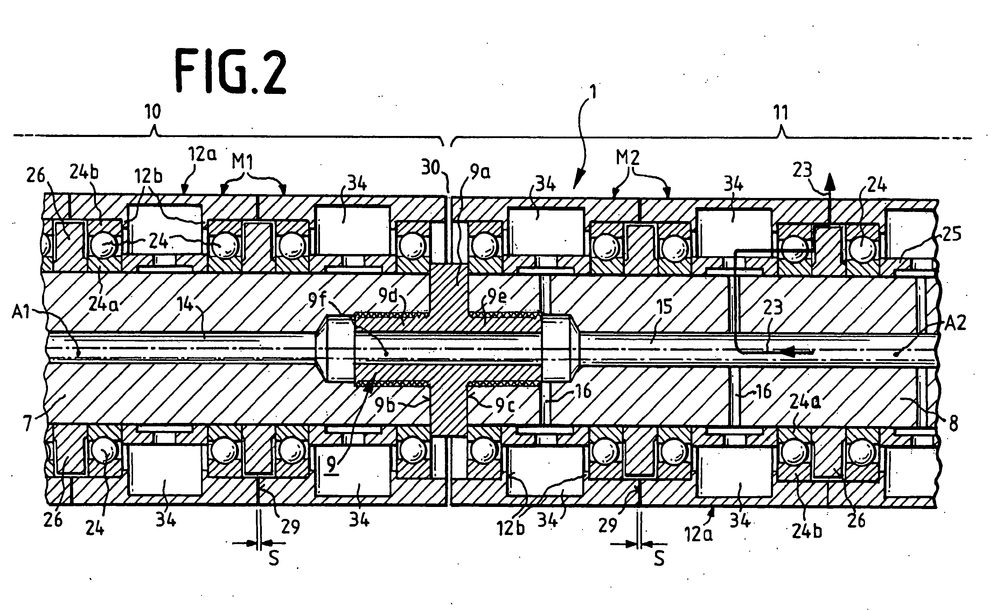

Ein Ausführungsbeispiel des Erfindungsgegenstandes, seine Wirkungsweise und Vorteile werden nachfolgend anhand der Figuren 1 und 2 näher erläutert.

Es zeigen:
- Figur 1: einen Axialschnitt durch eine Breitstreckwalzenanordnung, die zwischen zwei Seitenwänden einer Vakuumkammer angeordnet ist, und
- Figur 2: den Ausschnitt aus dem Rahmen II in Figur 1 in stark vergrössertem Massstab.

In Figur 1 ist eine Breitstreckwalzenanordnung 1 dargestellt, die mittels zweier Halterungen 2 und 3 an den Innenseiten zweier paralleler senkrechter Kammerwände 4 und 5 einer nur angedeuteten Vakuumkammer V gehalten ist. Ein Lageausgleich, der durch Temperaturänderungen der Walzenanordnung und/oder Druckänderungen an den Kammerwänden 4 und 5 eintreten kann, wird über eine Schiebeführung 6 ausgeglichen.

Die Breitstreckwalzenanordnung 1 besitzt zwei rohrförmige Stützkörper 7 und 8, die an ihren wandungsfernen Enden in einer Mittenebene E-E durch ein Kupplungsteil 9 lagefest miteinander verbunden sind. Auf diesen Stützkörpern 7 und 8 sind zwei Gruppen 10 und 11 von jeweils sieben Walzenabschnitten 12 mit rotationssymmetrischen Oberflächen 12a gelagert, die als Kreis-Kegelstumpfflächen ausgebildet sind und stufenlos aneinander gereiht sind. Die jeweils kleineren Umfangskreise der Deckflächen sind bei jeder Gruppe 10 bzw. 11 auf die Mittenebene E-E ausgerichtet, die jeweils grösseren Umfangskreise der Basisflächen sind bei jeder Gruppe 10 bzw. 11 auf die Kammerwände 4 bzw. 5 ausgerichtet. Die in Figur 1 obersten Mantellinien M1 und M2 fluchten linear und bilden eine gemeinsame Abzugslinie für ein hier nicht gezeigtes Band. Dies setzt voraus daß die Achsen A1 und A2 beider Gruppen 10 und 11 in einem spitzen Winkel von beispielhaft 0,8 Grad zueinander stehen.

Die Stützkörper 7 und 8 besitzen konzentrische Längsbohrungen 14 bzw. 15, von denen radiale Bohrungen 16 zu den einzelnen Wälzlagern führen, was in Figur 2 nur für die rechte Gruppe 11 der Walzenabschnitte 12 näher dargestellt ist, aber auch für die linke Gruppe 10 gilt. Die rechte Längsbohrung 15 führt zu einem gleichfalls hohlen Rohrstück 17, das einen seitlichen Anschlussteil 17a aufweist. Hiermit hat es folgende Bewandtnis.

Zum Zwecke eines Bandwechsels ist die Vakuumkammer auf Umgebungsdruck zu fluten, was zur Zeitersparnis durch ein Flutventil grossen Querschnitts geschieht. Selbst wenn diesem Ventil ein Staubfilter zugeordnet ist, so wird doch durch den starken Luftstrom Staub aufgewirbelt, der sich irgendwo abgesetzt hat. Dieser Staub tendiert dazu, auch in die Breitstreckwalzenanordnung einzudringen und deren Lager zu blockieren, so daß häufigere Zerlegungen und Reinigungen der Breitstreckwalzenanordnung notwendig sind. Besonders gefährlich ist die beim Beschichten von Bändern mit Zink auftretende Bildung von Zinkstaub, der mit Sauerstoff Zinkoxid bildet, das sich sowohl in den Lagern als auch in Spalten und Gehäusen von Einbauteilen absetzt.

Dem kann wie folgt durch die Erfindung entgegen gewirkt werden: Vor der Stillstandsphase, d.h. vor dem Beginn der Belüftung und dem öffnen der Vakuumkammer, wird Umgebungsluft 18 über ein Filter 19, eine Schmierstoffquelle 20 (z.B. einen Öl-Vernebler) und ein Stell- oder Dosierventil 21 sowie eine Leitung 22 dem Anschlussteil 17a in geringer Menge zugeführt, die gerade für den nächsten Bandbehandlungszyklus ausreicht. Einer dieser Strömungswege für den Ölnebel ist in Figur 2 durch die Linie 23 angedeutet. Dabei sind der Druck und die Dosierung so abgestimmt, dass zumindest der grösste Teil des öls in den Wälzlagern zurückbleibt.

Dies hat den zusätzlichen Vorteil, dass die der Breitstreckwalzenanordnung während des Flutens der Kammer zugeführte Luft das Eindringen von Staub und anderen Partikeln in die Breitstreckwalzenanordnung verhindert. Dabei kann auch der Schmierstoffzusatz unterbrochen oder die Schmierstoffquelle umgangen werden.

Hinter dem Filter 19 ist eine Zweigleitung 22a angeschlossen, die zu zwei Einbauteilen 13 und 13a innerhalb der Vakuumkammer V führt. Eine Mengenregelung der Luft kann durch eine hier nicht gezeigt Pumpe und/oder durch gleichfalls nicht gezeigte regelbare Drosselventile oder Drosselblenden erfolgen

Aus Figur 2 geht unter Verwendung der bisherigen Bezugszeichen folgendes hervor: Das Kupplungsteil 9 besteht aus einem Ringflansch 9a mit zwei ebenen Seitenflächen 9b und 9c, von denen in Normalenrichtung jeweils ein Gewindestutzen 9d und 9e absteht. Die Seitenflächen 9b und 9c stehen unter dem gleichen spitzen Winkel von beispielsweise 0,8 Grad zueinander wie die Achsen A1 und A2. Auf die Gewindestutzen 9d und 9e sind die rohrförmigen Stützkörper 7 und 8 bis zum Anschlag an die Seitenflächen 9d und 9e aufgeschraubt. Dadurch bildet die Baugruppe aus dem Kupplungsteil 9 und den Stützkörpern 7 und 8 eine lage- und biegefeste Trageinheit für die beiden Gruppen 10 und 11 der Walzenabschnitte 12 und die lineare Ausrichtung der Mantellinien M1 und M2. Das Kupplungsteil 9 besitzt eine Durchgangsbohrung 9f für die Verbindung der Längsbohrungen 14 und 15.

Auf die besagte Baugruppe aus dem Kupplungsteil 9 und den Stützkörpern 7 und 8 ist von beiden Enden her je eine Reihenanordnung von Wälzlagern 24 mit Innenringen 24a und Aussenringen 24b, gelochten Distanzringen 25 kleinen Aussendurchmessers und ungelochten Distanzringen 26 grösseren Aussendurchmessers aufgeschoben und durch Muttern 27 und 28 (Figur 1) gegeneinander verspannt. Auf jeweils zwei Wälzlagern 24 sind die Walzenabschnitte 12 verschiebungsfest gelagert, und zwar jeweils durch radial einwärts gerichtete Innenflansche 12b, die seitlich an den Aussenringen 24b der Wälzlager 24 anliegen. Abgesehen von den Innendurchmessern der Distanzringe 26 sind deren Seitenwände nach aussen hin stufenförmig zurückgesetzt, und der Aussendurchmesser ist kleiner als derjenige der Aussenringe 24b, so dass auf dem Aussenumfang der stillstehenden Distanzinge 26 keine Berührung mit benachbarten rotieren Bauteilen, insbesondere mit den Walzenabschnitten 12 möglich ist.

Die axialen Abmessungen sind dabei so getroffen, dass zwischen den Walzenabschnitten 12 Ringspalte 29 mit Spaltweiten "s" von beispielhaft 0,2 mm gebildet werden, wodurch relative Drehbewegungen zwischen den einzelnen Walzenabschnitten 12 ermöglicht werden. Bezogen auf gegenüber liegende imaginäre Fixpunkte der beiden unmittelbar benachbarten Walzenabschnitte 12 beider Gruppen 10 und 11 im Bereich des Kupplungsteils 9 bewegen sich die besagten Fixpunkte in der Weise, daß die Breite eines Spaltes 30 im Bereich des Kupplungsteils 9 beim Umlauf beispielhaft periodisch zwischen 0,89 mm (in Figur 2 unten) und 1,53 mm (oben) schwankt. Die lineare Ausrichtung der Mantellinien M1 und M2 bleibt beim Umlauf der Walzenabschnitte unverändert. Wichtig ist dabei, dass durch diese brückenartige Bauweise die Umfangsgeschwindigkeit der Walzenabschnitte 12 im Bereich ihrer Mantellinien M1 und M2 auf beiden Seiten des Kupplungsteils 9 identisch ist.

Die Walzenabschnitte 12 beider Gruppen 10 und 11 rotieren im Betrieb durch die Brückenbildung der Baugruppe aus dem Kupplungsteil 9 und den Stützkörpern 7 und 8 absolut mit der gleichen Umfangsgeschwindigkeit, wodurch Schlupf- und Reibungsbewegungen des Bandes auf den kegelförmigen Walzenabschnitten 12 in Umfangsrichtung auf ein Minimum reduziert werden. Diese lokalen Schlupf- und Reibungsbewegungen nehmen mit zunehmender Anzahl der Walzenabschnitte 12 pro Längeneinheit der Breitstreckwalzenanordnung 1 weiter ab.

Durch die Reihenanordnung von Walzenabschnitten 12 und deren Wälzlagern 24 und Distanzringen 25 und 26 wird gegenüber den Stützkörpern 7 und 8 je ein durchgehender Zwischenraum 34 gebildet, der durch die Gaszufuhr frei geblasen und frei gehalten wird.

### Bezugszeichenliste:

- 1: Breitstreckwalzenanordnung
- 2: Halterung
- 3: Halterung
- 4: Kammerwand
- 5: Kammerwand
- 6: Schiebeführung
- 7: Stützkörper
- 8: Stützkörper
- 9: Kupplungsteil
- 9a: Ringflansch
- 9b: Seitenfläche
- 9c: Seitenfläche
- 9d: Gewindestutzen
- 9e: Gewindestutzen
- 9f: Durchgangsbohrung
- 10: Gruppe
- 11: Gruppe
- 12: Walzenabschnitte
- 12a: Oberflächen
- 12b: Innenflansche
- 13: Einbauteil
- 13a: Einbauteil
- 14: Längsbohrung
- 15: Längsbohrung
- 16: Bohrungen
- 17: Rohrstück
- 17a: Anschlussteil
- 18: Umgebungsluft
- 19: Filter
- 20: Schmierstoffquelle
- 21: Stell- oder Dosierventil
- 22: Leitung
- 22a: Zweigleitung
- 23: Linie
- 24: Wälzlager
- 24a: Innenringe
- 24b: Aussenringe
- 25: Distanzringe
- 26: Distanzringe
- 27: Mutter
- 28: Mutter
- 29: Ringspalte
- 30: Spalt
- 34: Zwischenräume

- A1: Achse
- A2: Achse
- E-E: Mittenebene
- L: Abzugslinie
- M1: Mantellinien
- M2: Mantellinien
- "s": Spaltweiten
- V: Vakuumkammer

## Patentansprüche

1. Verfahren zum Betrieb von Vakuumanlagen mit Druckänderungen zwischen dem Betriebsdruck und dem Umgebungsdruck, die in einer Vakuumkammer (V) Einbauteile (12, 13, 13a, 24) aus der Gruppe Elektronikbauteile, Transformatoren, Motoren, Wälzlager und Führungswalzen besitzen, die mit belüftbaren Umhüllungen versehen sind, wobei die Führungswalzen (12) mit Wälzlagern (24) versehen sind, die innerhalb der Umhüllungen auf Stützkörpern (7, 8) gehalten sind, **dadurch gekennzeichnet, dass** vor dem Fluten der Vakuumkammer (V) in die Umhüllungen ein Gas eingeleitet wird, durch das Festkörper aus der Gruppe Staub und Partikel aus den Umhüllungen herausgeblasen werden und das Eindringen von Festkörpern in die Umhüllungen verhindert wird.

2. Verfahren nach Anspruch 1, **dadurch gekennzeichnet, dass** die Umhüllungen aus hohlen Walzen bzw. Walzenabschnitten (12) bestehen, in denen sich Wälzlager (24) mit Innenringen (24a) und Aussenringen (24b) befinden und dass das Gas durch die Ringspalte zwischen den Innenringen (24a) und den Aussenringen (24b) hindurch geblasen wird.

3. Verfahren nach mindestens einem der Ansprüche 1 und 2, **dadurch gekennzeichnet, dass** das Gas während des gesamten Flutvorganges der Vakuumkammer (V) durch die Umhüllungen hindurch geführt wird.

4. Verfahren nach mindestens einem der Ansprüche 1 bis 3, **dadurch gekennzeichnet, dass** die zugeführte Gasmenge geregelt wird.

## Claims

1. Method of operating vacuum systems with pressure variations between operating pressure and environmental pressure, comprising in a vacuum chamber (V) assembly components (12, 13, 13a, 24) from a group of electronic assembly components, transformers, motors, roller bearings and guide rollers which are provided with ventilated sleeves, and the guide rollers (12) are provided with roller bearings (24) which are held within the sleeves on support bodies (7, 8), **characterised in that** prior to flooding of the vacuum chamber (V) a gas is introduced into the sleeves through which solids of a group of dust and particles are blown out of the sleeves and entry of solids into the sleeves is prevented.

2. Method according to Claim 1, **characterised in that** the sleeves are composed of hollow rollers or roller sections (12) which include roller bearings (24) with internal rings (24a) and external rings (24b), and the gas is blown through the annular gap between the internal rings (24a) and the external rings (24b).

3. Method according to at least one of Claims 1 and 2, **characterised in that** the gas is during the entire flooding process of the vacuum chamber (b) ducted through the sleeves.

4. Method according to at least one of Claims 1 to 3, **characterised in that** the delivered volume of gas is regulated.

## Revendications

1. Procédé en vue du fonctionnement d'installations à vide avec variation de pression entre la pression de fonctionnement et la pression ambiante, qui présentent dans une chambre à vide (V) des pièces incorporées (12, 13, 13a, 14) appartenant au groupe des composants électroniques, des transformateurs, des moteurs, des paliers à roulement et des cylindres de guidage, qui sont équipés d'enveloppes pouvant être ventilées, où les cylindres de guidage (12) sont équipés des paliers à roulement (24), qui sont maintenus à l'intérieur des enveloppes sur des éléments d'appui (7, 8), **caractérisé en ce que**, avant la submersion de la chambre à vide (V), un gaz est introduit dans les enveloppes, grâce auquel des corps solides appartenant au groupe de la poussière et des particules sont expulsés des enveloppes et l'introduction de corps solides dans les enveloppes est empêchée.

2. Procédé selon la revendication 1, **caractérisé en ce que** les enveloppes se composent de cylindres ou de tronçons de cylindre (12) creux, dans lesquels se trouvent les paliers à roulement (24) équipés de bagues intérieures (24a) et de bagues extérieures (24b) et **en ce que** le gaz est soufflé à travers l'espace annulaire entre les bagues intérieures (24a) et les bagues extérieures (24b).

3. Procédé selon au moins l'une des revendications 1 et 2, **caractérisé en ce que** le gaz est dirigé à travers les enveloppes pendant tout le procédé de submersion de la chambre à vide (V).

4. Procédé selon au moins l'une des revendications 1 à 3, **caractérisé en ce que**, la quantité de gaz amenée est régulée.
